# EUROPEAN PATENT SPECIFICATION

(11) **EP 3 913 632 B1**
(45) Date of publication and mention of the grant of the patent: **03.01.2024**
(21) Application number: 20918133.8
(22) Date of filing: 10.09.2020
(51) Int. Cl.: G11C 29/14, G11C 29/12, G11C 29/44, G11C 29/48, G11C 29/56, G11C 29/00

(54) **METHOD FOR TESTING MEMORY AND RELATED EQUIPMENT**
VERFAHREN UND VORRICHTUNG ZUR ÜBERPRÜFUNG EINES SPEICHERS
PROCÉDÉ POUR TESTER UNE MÉMOIRE ET ÉQUIPEMENT ASSOCIÉ

(30) Priority: 11.03.2020 CN 202010166581
(43) Date of publication of application: 24.11.2021
(73) Proprietor: Changxin Memory Technologies, Inc., Hefei, Anhui 230601 (CN)
(72) Inventor: SHI, Chuanqi, Hefei, Anhui 230601 (CN); CHANG, Heng-Chia, Hefei, Anhui 230601 (CN); DING, Li, Hefei, Anhui 230601 (CN)
(74) Representative: V.O.
(86) International application number: PCT/CN2020/114513
(87) International publication number: WO 2021/179559

(56) References cited:
- CN-A- 106 556 793
- CN-A- 107 068 196
- CN-A- 108 899 061
- US-A1- 2001 040 829
- US-A1- 2004 013 016
- US-A1- 2004 179 421
- US-A1- 2006 190 789
- US-A1- 2007 168 808
- US-A1- 2014 164 833
- US-A1- 2019 198 131

## Description

### CROSS-REFERENCE TO RELATED APPLICATION

The application claims priority to Chinese patent application No.: 202010166581.1, filed on March 11, 2020 and entitled "Method and Device for Testing Memory".

### TECHNICAL FIELD

The disclosure relates to the technical field of semiconductor testing, and more particularly, to a method and a related device for testing a memory.

### BACKGROUND

As a size of semiconductor process continues to decrease and a scale of Integrated Circuit (IC) design continues to increase, highly complex IC products are facing increasingly severe challenges to achieve high reliability, high quality, low costs, and short product launch cycles. On one hand, as the size of semiconductor process decreases, more and more types of potential defects may exist in the memory. On the other hand, with the increasing complexity of the IC products, a proportion of memories such as Random-Access Memory (RAM) in the IC products is increasing.

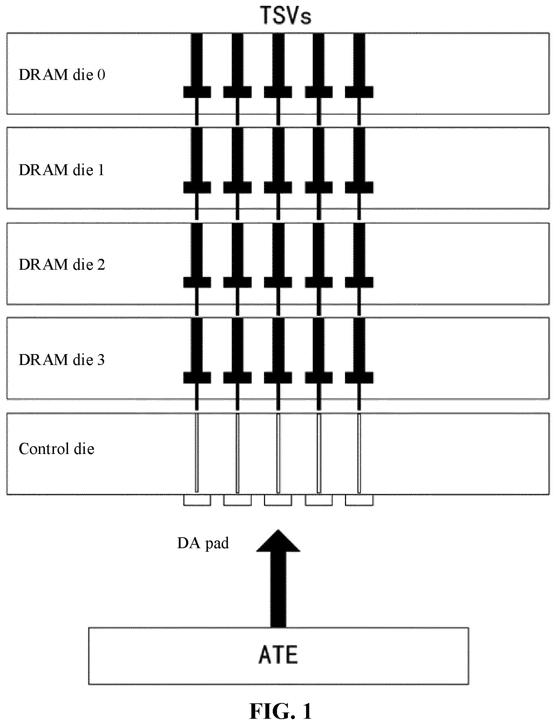

As shown in FIG. 1, when an Automatic Test Equipment (ATE) is used to test a Dynamic Random Access Memory (DRAM) through Direct Access Pads (DA Pads), as a bit width of the DRAM increases, one touch down (i.e., one contact between a probe card that is used for the test and the DA pads) may not be able to test a whole wafer. Additionally, a test clock is provided by the ATE directly to a DRAM die, and a high-speed machine is required for high-speed testing, which will increase the test cost. Furthermore, it is necessary to provide a large number of DA pads on a control die, resulting in high costs of preparing the probe card.

It should be noted that the information disclosed in the aforementioned background part is only used to enhance the understanding of the background of the disclosure, and therefore may include information that does not constitute the prior art known to those of ordinary skill in the art.

Document US 2001040829 A1 discloses a test interface circuit configured to carry out an operational test based on a signal input to test pin terminals by directly accessing a DRAM core. The test interface circuit includes: a frequency multiplication circuit configured to generate an internal test clock signal by multiplying the frequency of an external test clock signal input to the test pin terminal; and a data shifter configured to shift read data from the DRAM core which operates according to the internal test clock signal in a test mode by N clock cycles (N is an integer of at least 0 determined by column latency) of the internal test clock signal to output the read data from the test pin terminals in synchronization with the external clock test signal.

Document US 2004013016 A1 discloses a semiconductor circuit device comprising: a memory core operating synchronously with a memory dock signal; a memory transferring circuit transferring at least a signal to said memory core synchronously with a test clock signal; a timing selecting circuit receiving at least said memory clock signal and test clock signal, and selecting one of at least said memory clock signal and said test clock signal; and a timing transferring circuit for taking in and transferring externally an output signal of said timing selecting circuit synchronously with a correcting test clock signal.

Document US 2004179421 A1 discloses a semiconductor memory device comprising: an array of memory cells; an address input circuit for receiving an external address in response to an address clock signal; a selecting circuit for selecting a memory cell in response to an address output from the address input circuit; a data output circuit for outputting the data read out from the selected memory cell in response to first and second data clock signals; and an internal clock generating circuit for generating the address clock signal and the first and second data clock signals in response to an external clock signal and a complementary clock signal thereof, wherein the address clock signal and the first and second data clock signals have twice the frequency (or half the period) of the external clock signal when in a test mode.

Document US 2019198131 A1 discloses a system including a first semiconductor apparatus and a second semiconductor apparatus. Each of the first and second semiconductor apparatuses may receive reference data and a first clock signal. The first semiconductor apparatus may generate a first internal clock signal from the first clock signal, and may output the reference data as transmission data based on the first internal clock signal. The second semiconductor apparatus may generate a second internal clock signal from the first clock signal, and may receive the transmission data based on the second internal clock signal. The second semiconductor apparatus may generate an error detection signal based on the received data and the reference data.

### SUMMARY

In view of the limitations of the existing techniques described above, the disclosure provides a method and a related device for testing a memory to overcome technical problems of the high test cost, the long test cycle, and limited test speed caused by the use of ATE to test the memory in the aforementioned related technologies.

One aspect of the disclosure is directed to a method for testing a memory according to independent claim 1.

The method includes: obtaining a test instruction; generating, in response to the test instruction, a test clock signal, a to-be-tested address and to-be-tested data; determining a to-be-tested memory from memories of a storage device, the storage device comprising a control die that has a built-in self-test circuit (BIST) on which the memories are stacked, wherein each of the memories has a limited quantity of command pins connected to the BIST circuit to obtain the test instruction from the ATE; writing the to-be-tested data into a storage unit corresponding to a to-be-tested address of the to-be-tested memory; reading output data from the storage unit corresponding to the to-be-tested address of the to-be-tested memory; and comparing the to-be-tested data with the output data corresponding to the to-be-tested address, to obtain a test result of the to-be-tested memory, characterized in that, the BIST circuit comprises a first-in-first-out queue; and the step of obtaining the test instruction comprises: buffering a command signal from an automatic test equipment in the first-in-first-out queue, wherein a frequency of the test clock signal is equal to the frequency of the clock signal output by the automatic test equipment, and a phase of the test clock signal is different from a phase of the clock signal output by the automatic test equipment, wherein the BIST circuit further comprises a clock signal generator that generates the test clock signal; and reading the command signal from the first-in-first-out queue.

In some embodiments of the disclosure, the step of obtaining the test instruction further includes determining a target operating mode of the self-test circuit; and parsing the command signal based on the target operating mode and determining the command signal to be the test instruction. The step of determining a target operating mode of the self-test circuit includes obtaining, from the automatic test equipment, first configuration information; and determining, based on the first configuration information, the target operating mode.

In some embodiments of the disclosure, the method further includes: obtaining, from the automatic test equipment, second configuration information; determining, based on the second configuration information, the frequency of the test clock signal; and generating, by using the clock signal generator, a test clock signal that has the frequency of the clock signal generator.

In some embodiments of the disclosure, the step of reading the command signal from the first-in-first-out queue includes: obtaining, from the automatic test equipment, third configuration information; determining, based on the third configuration information, a reading frequency of the command signal; and, in response to the reading frequency being equal to the frequency of the test clock signal, reading, based on the test clock signal, the command signal from the first-in-first-out queue.

In some embodiments of the disclosure, the step of reading the command signal from the first-in-first-out queue further includes: in response to the reading frequency being equal to the frequency of the clock signal output by the automatic test equipment, reading, based on the clock signal output by the automatic test equipment, the command signal from the first-in-first-out queue.

In some embodiments of the disclosure, the step of determining the to-be-tested memory from the memories of the storage device includes: obtaining, from the automatic test equipment, fourth configuration information; and determining, based on the fourth configuration information, the to-be-tested memory, the to-be-tested memory being one or more target memories in the storage device.

In some embodiments of the disclosure, the step of writing the to-be-tested data into the storage unit corresponding to the to-be-tested address of the to-be-tested memory includes: in response to the to-be-tested memory being one target memory in the storage device, writing the to-be-tested data into a storage unit corresponding to a to-be-tested address of the target memory.

In some embodiments of the disclosure, the step of writing the to-be-tested data into the storage unit corresponding to the to-be-tested address of the to-be-tested memory includes: in response to the to-be-tested memory being a plurality of target memories in the storage device, writing each of the to-be-tested data into storage units corresponding to a to-be-tested address of a respective one of the plurality of target memories.

In some embodiments of the disclosure, the step of comparing the to-be-tested data with the output data corresponding to the to-be-tested address, to obtain the test result of the to-be-tested memory includes: comparing the to-be-tested data with the output data corresponding to the to-be-tested address, to obtain a comparison result; and in response to the comparison result being not matching, recording the to-be-tested address corresponding to the to-be-tested data as an incorrect address, the test result including the incorrect address.

In some embodiments of the disclosure, the BIST circuit includes a volatile storage unit and a non-volatile storage unit. The method further includes writing the test result of the to-be-tested memory into the volatile storage unit; and writing the test result in the volatile storage unit into the non-volatile storage unit for storage.

In some embodiments of the disclosure, the BIST circuit includes a non-volatile storage unit, configured to store an incorrect address of the to-be-tested memory. The step of generating, in response to the test instruction, the to-be-tested address includes obtaining the incorrect address stored in the non-volatile storage unit; and skipping automatically the incorrect address when generating the to-be-tested address.

Another aspect of the disclosure is directed to a computer storage medium according to independent claim 12. The computer storage medium stores a computer program. Upon being executed by a processor, the computer program causes the processor to perform any one of the foregoing methods for testing the memory.

### BRIEF DESCRIPTION OF THE DRAWINGS

The accompanying drawings illustrate embodiments in accordance with the disclosure, and are used to explain the principle of the disclosure. The accompanying drawings in the following descriptions show merely some embodiments of the disclosure. Those of ordinary skill in the art may still derive other accompanying drawings from these accompanying drawings without creative efforts.
FIG. 1 is a schematic diagram of testing a DRAM in the art.
FIG. 2 is a schematic flowchart of a method for testing a memory according to an embodiment of the disclosure.
FIG. 3 is a schematic diagram of a method for testing a memory according to an embodiment of the disclosure.
FIG. 4 is a schematic diagram of a method for testing a memory according to an embodiment of the disclosure.
FIG. 5 is a schematic diagram of a method for testing a memory according to an embodiment of the disclosure.
FIG. 6 is a schematic diagram of a method for testing a memory according to an embodiment of the disclosure.
FIG. 7 is a schematic diagram of a method for testing a memory according to an embodiment of the disclosure.
FIG. 8 is a schematic diagram of a method for testing a memory according to an embodiment of the disclosure.
FIG. 9 is a schematic diagram of a method for testing a memory according to an embodiment of the disclosure that does not fall into the scope of the claims.
FIG. 10 is a schematic diagram of a method for testing a memory according to an embodiment of the disclosure that does also not fall into the scope of the claims.
FIG. 11 is a schematic diagram of a device for testing a memory according to an embodiment of the disclosure.

### DETAILED DESCRIPTION

Exemplary implementations are comprehensively described with reference to the accompanying drawings. However, the exemplary implementations in this specification can be implemented in various forms, and should not be construed as being limited to the embodiments set forth herein. On the contrary, these provided implementations may make the disclosure more comprehensive and complete, and the concepts of the exemplary implementations may be comprehensively conveyed to those skilled in the art. Same reference signs in the figures represent same or similar parts, and therefore are not repeatedly described. The accompanying drawings are merely schematic diagrams of the present specification and are not necessarily drawn to scale.

Although relative terms such as "above" and "under" are used in the specification to describe a relative relationship of a component with a reference sign to another component with a reference sign, these terms are used in the specification for convenience only, for example, for indicating directions in the examples described according to the accompanying drawings. It can be understood that if a device with a reference sign is inverted, a component described to be "above" may become a component described to be "under." When a structure is "above" another structure, it may mean that the structure is integrated onto the another structure, or that the structure may be "directly" disposed on the another structure, or that the structure may be "indirectly" disposed on the another structure by using another structure.

The terms of "one", "a", and "the" are used to indicate an existence of one or more elements/components/etc. The terms of "include" and "have" are used to indicate open inclusion and the existence of an element/a component/etc., in addition to the listed element/component/etc. The terms such as "first" and "second" are merely used as a sign and constitute no limitation on the number of its object.

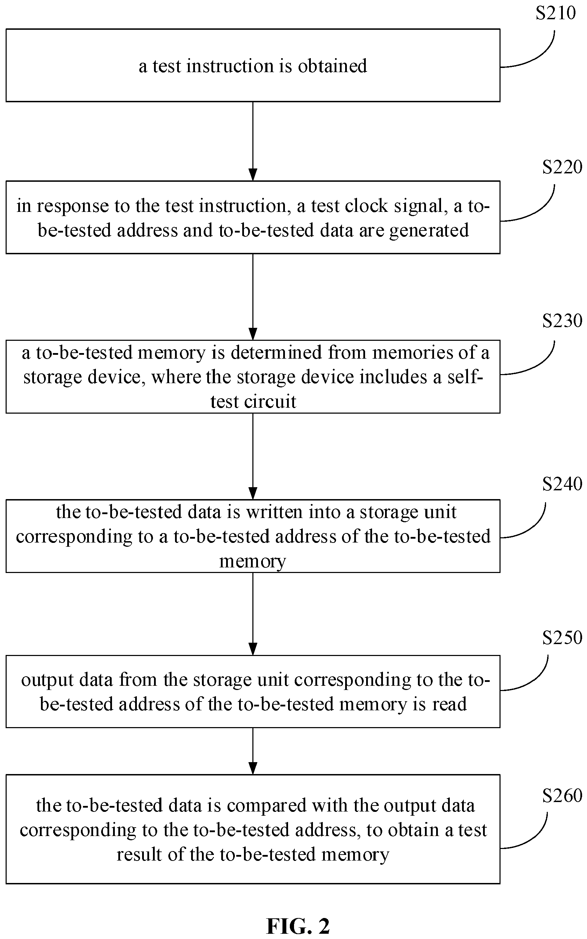

FIG. 2 is a schematic flowchart of a method for testing a memory according to an embodiment of the disclosure. As shown in FIG. 2, the method provided in this embodiment of the disclosure includes the following steps of S210 to S260.

In some embodiments, the method is performed by a self-test circuit. The self-test circuit is an internal circuit with a test capability in a storage device, and therefore also is referred to as a built-in self-test (BIST) circuit. The BIST circuit is disposed in a control die of a storage device corresponding to a to-be-tested memory, or is disposed in a memory die such as a DRAM die in the storage device. This is not limited in the disclosure.

In step of S210, a test instruction is obtained.

In some embodiments, the self-test circuit includes a First-In-First-Out (FIFO) queue.

The step of obtaining the test instruction includes buffering a command signal from an automatic test equipment (ATE) in the FIFO queue. A frequency of the test clock signal is equal to the frequency of the clock signal output by the ATE, and a phase of the test clock signal is different from a phase of the clock signal output by the ATE. Then, the test instruction may be obtained by reading the command signal from the FIFO queue.

According to embodiments of the disclosure, the data sent by the ATE to the BIST circuit can be buffered in the built-in FIFO queue in the BIST circuit. On one hand, the problem of frequency mismatch between a low-speed clock of the ATE and a high-speed clock of the BIST circuit may be resolved, thereby preventing the data sent by the ATE to the BIST circuit from being lost. Even if the ATE and the BIST circuit use the same clock frequency, phase inconsistency between the ATE and the BIST circuit may also cause the data loss. On the other hand, the data in of the BIST circuit, to avoid frequent bus operations and reduce the burden on the central processing unit.

In some embodiments of the disclosure, the step of reading the command signal from the FIFO queue includes: obtaining third configuration information from the ATE; determining a reading frequency of the command signal based on the third configuration information; and in response to the reading frequency being equal to the frequency of the test clock signal, reading the command signal from the FIFO queue based on the test clock signal.

In some embodiments of the disclosure, the step of reading the command signal from the FIFO queue further includes: in response to the reading frequency being equal to the frequency of the clock signal output by the ATE, reading the command signal from the FIFO queue based on the clock signal output by the ATE.

In some embodiments of the disclosure, the ATE sends the third configuration information to the BIST circuit to specify the frequency of reading the buffered command signal from the FIFO queue in the BIST circuit. It may be specified that the buffered command signal is read from the FIFO queue in the BIST circuit based on a high-speed clock generated by the BIST circuit or based on a low-speed clock of the ATE. This is not limited in the disclosure.

In some embodiments of the disclosure, the step of obtaining the test instruction further includes: determining a target operating mode of the self-test circuit; and parsing the command signal based on the target operating mode and determining the command signal to be the test instruction.

In some embodiments of the disclosure, the step of determining the target operating mode of the self-test circuit includes: obtaining first configuration information from the ATE; and determining the target operating mode based on the first configuration information.

In some embodiments, since the BIST circuit has a limited quantity of command pins, and the quantity of instructions represented by the parsed command signals is limited, the various command signals sent by the ATE to the BIST circuit may not be effectively represented. Therefore, different operating modes may be set. In the different operating modes, a same pin signal may represent different command signals according to the different operating modes, so that the limited command pins may be reused to parse more different command signals. For example, an AND gate, one of the simplest gates, may have two input pins, which may represent only four different command signals: "11", "01", "10", and "00". When different operating modes are introduced, "11", "01", "10", and "00" may respectively represent more instructions. For example, in a first operating mode (e.g., a test mode in which a DRAM die is tested), "11", "01", "10", and "00" may respectively represent four different instructions during the test of the DRAM die. For example, in a second operating mode (e.g., a test mode in which a control die is tested), "11", "01", "10", and "00" may respectively represent four different instructions during the test of the control die. The examples herein are merely used for description, and actual types, quantities, control logic of the operating modes may be determined based on an actual need and are not limited in the disclosure.

In the step of S220, in response to the test instruction, a test clock signal, a to-be-tested address and to-be-tested data are generated.

In some embodiments, the self-test circuit further includes a clock signal generator. A clock signal output by the clock signal generator that is built in the BIST circuit is configured to test the memory, and therefore the clock signal also is referred to as the test clock signal.

The method for testing the memory further includes obtaining second configuration information from the ATE; determining the frequency of the test clock signal based on the second configuration information; and generating a test clock signal that has the frequency of the test clock signal by using the clock signal generator.

When performing the method, the BIST circuit uses a computer to generate various pieces of to-be-tested data for testing a to-be-tested memory by using a to-be-tested data generation algorithm. The ATE reads the to-be-tested data from the computer and send the to-be-tested data to the BIST circuit; then, the BIST circuit sends the to-be-tested data to the to-be-tested memory for testing. Alternatively, the to-be-tested data generation algorithm is built in the ATE or the BIST circuit, and the ATE or the BIST circuit generates the to-be-tested data by itself. When a plurality of memory dies in the storage device corresponding to the control die share a peripheral pin, one or more memory dies to which the to-be-tested data is to be sent is need to be firstly determined from the plurality of memory dies. In this case, the ATE firstly sends the obtained to-be-tested data to the control die, and the control die may determine which of the memory dies as the to-be-tested memory. And then, the received to-be-tested data is sent to the to-be-tested memory for testing. As such, the ATE tests the plurality of memory dies in parallel by using a small quantity of peripheral pins of the storage device, without being limited by the quantity of peripheral pins of the storage device.

In the step of S230, a to-be-tested memory is determined from memories of a storage device. The storage device includes a self-test circuit.

In some embodiments of the disclosure, the step of determining the to-be-tested memory from the memories of the storage device includes: obtaining fourth configuration information from the ATE; and determining the to-be-tested memory based on the fourth configuration information. The to-be-tested memory may be one or more target memories in the storage device.

In some embodiments of the disclosure, the ATE sends the fourth configuration information to the BIST circuit to specify to test a specific memory in the storage device, or test all of or some of the memories in parallel. The BIST circuit may simultaneously test all of the memory dies in the storage device, thereby reducing the test time, improving the test efficiency, and reducing the test cost.

In some embodiments of the disclosure, the storage device may further include a control die, and the self-test circuit may be arranged in the control die.

In some embodiments of the disclosure, the memories of the storage device may be vertically stacked above or beneath the control die. Alternatively, the memories of the storage device may be horizontally interconnected to the control die. The disclosure will not be limited in this regard.

In some embodiments of the disclosure, the to-be-tested memory may include a plurality of memory dies, and the plurality of memory dies may belong to a same storage device. Additionally, the control die and the plurality of memory dies may also belong to the same storage device. In some embodiments of the disclosure, the plurality of memory dies of the to-be-tested memory may be vertically stacked above the control die successively. In some other embodiments of the disclosure, the plurality of memory dies of the to-be-tested memory may be vertically stacked beneath the control die successively. In other embodiments of the disclosure, the plurality of memory dies of the to-be-tested memory may be vertically stacked successively, and the plurality of memory dies vertically stacked successively may be horizontally interconnected to the control die. In some other embodiments of the disclosure, the plurality of memory dies of the to-be-tested memory and the control die may be horizontally distributed above the storage device. This will not be limited in the disclosure.

In some embodiments of the disclosure, the self-test circuit may be arranged in the memories of the storage device. The BIST circuit may also be disposed in any memory in the storage device in which the to-be-tested memory is arranged.

In some embodiments of the disclosure, the to-be-tested memory may be any type of memory, for example, a DRAM or a Static Random-Access Memory (SRAM). The to-be-tested memory may be one of, some of, or all of the memory dies in the storage device.

In the step of S240, the to-be-tested data is written into a storage unit corresponding to a to-be-tested address of the to-be-tested memory.

In some embodiments of the disclosure, the BIST circuit writes the to-be-tested data into the storage unit corresponding to the to-be-tested address of the to-be-tested memory according to the test clock signal generated in the foregoing steps.

In some embodiments of the disclosure, the step of writing the to-be-tested data into the storage unit corresponding to the to-be-tested address of the to-be-tested memory includes: in response to the to-be-tested memory being one target memory in the storage device, writing the to-be-tested data into a storage unit corresponding to a to-be-tested address of the target memory.

In some embodiments of the disclosure, when a certain memory in the storage device is specified by the BIST circuit for testing, the BIST circuit writes the to-be-tested data into storage units of the memory successively. For example, in response to the specified memory being a first memory in the storage device and the first memory having 10,000 storage units, the BIST circuit writes a first bit of the to-be-tested data into a first storage unit of the first memory, and write a second bit of the to-be-tested data into a second storage unit of the first memory, and so on.

In some embodiments of the disclosure, the step of writing the to-be-tested data into the storage unit corresponding to the to-be-tested address of the to-be-tested memory includes: in response to the to-be-tested memory being a plurality of target memories in the storage device, writing each of the to-be-tested data into storage units corresponding to a to-be-tested address of a respective one of the plurality of target memories.

In some embodiments of the disclosure, the BIST circuit tests all of the memories in the storage device in parallel; then, the BIST circuit respectively writes the to-be-tested data into the storage units of the memories successively. For example, when there are a total of four memories and each having 10,000 storage units, the BIST circuit respectively writes the first bit in the to-be-tested data into the first storage units of the four memories, and then respectively write the second bit in the to-be-tested data into the second storage units of the four memories, and so on.

In the step of S250, output data from the storage unit corresponding to the to-be-tested address of the to-be-tested memory is read.

In some embodiments of the disclosure, the BIST circuit reads the output data from the storage unit corresponding to the to-be-tested address of the to-be-tested memory based on the test clock signal generated in the foregoing step.

In the step of step S260, the to-be-tested data is compared with the output data corresponding to the to-be-tested address, to obtain a test result of the to-be-tested memory.

In some embodiments of the disclosure, the step of comparing the to-be-tested data and the output data corresponding to the to-be-tested address, to obtain the test result of the to-be-tested memory includes: comparing the to-be-tested data with the output data corresponding to the to-be-tested address, to obtain a comparison result; and in response to the comparison result being not matching, recording the to-be-tested address corresponding to the to-be-tested data as an incorrect address. The test result may include the incorrect address.

In an embodiment of the disclosure, the BIST circuit is be configured to test the to-be-tested memory. For example, the BIST circuit may input known character strings consisting of "0" and/or "1" to the storage units corresponding to addresses of the to-be-tested memory. After a certain delay, the BIST circuit reads the character strings from the storage units corresponding to the addresses, and successively perform an exclusive OR operation on the character strings that are previously input and the character strings that are subsequently read, to determine whether a specific storage unit has an error. In this case, an address of the storage unit having the error is be recorded; that is, a test result of the to-be-tested memory includes the address corresponding to the storage unit having the error in the to-be-tested memory, which may be referred to as the incorrect address.

In some embodiments of the disclosure, the self-test circuit includes a volatile storage unit (i.e., a Volatile Memory) and a non-volatile storage unit (i.e., a Non-volatile Memory). The method further includes writing the test result of the to-be-tested memory into the volatile storage unit; and writing the test result in the volatile storage unit into the non-volatile storage unit for storage.

In some embodiments of the disclosure, considering that the non-volatile storage unit has a low data writing speed when writing data and a high-speed clock signal is used by the BIST circuit when testing the to-be-tested memory, the generated test result firstly is written into the volatile storage unit to prevent the test result from being lost. Since the data writing speed of the volatile storage unit is greater than the data writing speed of the non-volatile storage unit, the loss of the test result data can be effectively avoided. Additionally, considering that data in the volatile storage unit may be lost after the volatile storage unit is powered off, the test result in the volatile storage unit may be periodically written into the non-volatile storage unit for storage.

In some embodiments of the disclosure, the self-test circuit includes a non-volatile storage unit, and the non-volatile storage unit is configured to store an incorrect address of the to-be-tested memory. And the step of generating, in response to the test instruction, the to-be-tested address includes: obtaining the incorrect address stored in the non-volatile storage unit; and skipping automatically the incorrect address when generating the to-be-tested address.

During an actual testing process, a same storage device or a same memory may be tested multiple times. To avoid repeatedly testing the same storage unit of the same memory, test results obtained in one or all previous test processes may be stored in the non-volatile storage unit. During a current testing, the storage units that have been tested may be firstly identified according to the test results stored in the non-volatile storage unit. In this case, the incorrect address may be automatically skipped when generating the to-be-tested address, to improve the test efficiency and avoid a waste of test resources.

In an actual design scenario of the storage device, a separate redundancy area may need to be designated in each memory, to store a test result of the memory in the testing process, such as the foregoing incorrect address. Therefore, the design area of the memory is used, and the redundancy area in each memory may need to be designed, which will increase the complexity of the control and architecture of the storage device. In some embodiments, the non-volatile storage unit may be provided in the BIST circuit, and the provided non-volatile storage unit may be configured to store the test results of all the memories in the storage device. Therefore, each memory in the storage device does not need to separately design its own redundant area, so that a volume of the storage device may be reduced, the structure and design of the storage device can be simplified.

In some embodiments of the disclosure, the BIST circuit further analyzes a cause of the error according to the obtained test result of the to-be-tested memory, to identify repairing information for repairing the storage unit having the error. The test result of the to-be-tested memory includes the address (i.e., the incorrect address) corresponding to the storage unit having the error in the to-be-tested memory and the repairing information for repairing the storage unit corresponding to the incorrect address. In other embodiments of the disclosure, the repairing information of the to-be-tested memory further includes spare circuit information in the to-be-tested memory. The spare circuit information refers to some redundant spare storage units in the memory to ensure the reliability, in addition to the storage units conventionally designed to store data. For example, 200 spare storage units are added to a first memory, in addition to conventional 10,000 storage units included in the first memory. During a testing process or an actual application process, in response that an error is found in the conventional 10,000 storage units, a faulty storage unit is directly replaced by a spare storage unit. The replacement refers to a replacement of the address of the storage unit instead of a physical replacement. Alternatively, while repairing the storage unit having the error, the spare storage unit is used to replace the storage unit having the error before the repairing process is completed to maintain the normal functionality of the memory.

According to the method for testing the memory disclosed in some embodiments of the disclosure, on one hand, the self-test circuit is added and used to complete the memory testing process, so that a whole wafer may be tested by using a small quantity of DA pads in one touch down.

An example is provided below to explain the method for testing the memory in greater details. The storage device is a DRAM in the example below. It is apparent that the method for testing the memory may be applicable to other types of memories, which will not be limited in the disclosure.

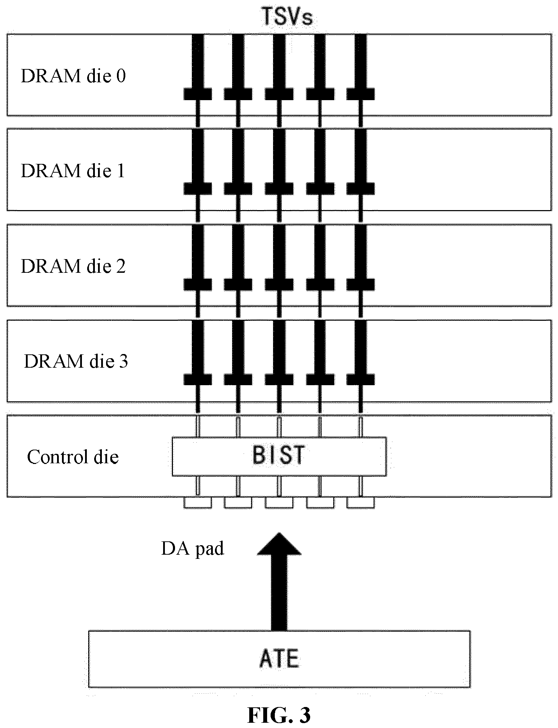

FIG. 3 is a schematic diagram of a method for testing a memory according to an embodiment of the disclosure. As shown in FIG. 3, a storage device includes four DRAM dies (DRAM dies 0 to 3) which are stacked above a control die, and the four DRAM dies may be electrically connected through Through-Silicon Vias (TSVs).

The control die may include a BIST circuit, and the DRAM dies 0 to 3 may be vertically stacked above the control die successively. In the stacked storage device, several DRAM dies may be vertically stacked together. Compared with a conventional storage device, the stacked storage device has advantages in line layout, bandwidth, and latency, etc. The stacked storage device may not only occupy less space compared to the conventional storage device, but also may have a shorter die spacing, resulting in a shorten signal transmission path and a less signal delay. In the stacked storage device, the TSV technology may be used to perforate vias in the edges or specific positions of the DRAM dies, and these vias may be used as pathways for wiring and completing vertical interconnection.

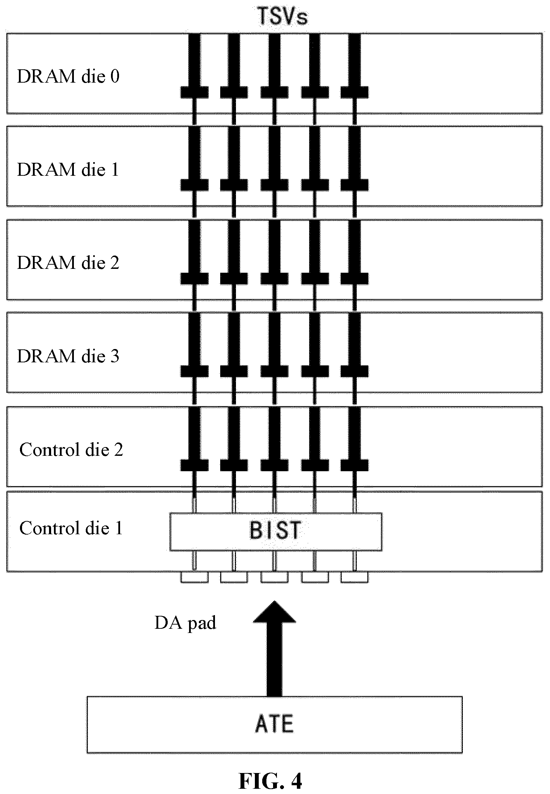

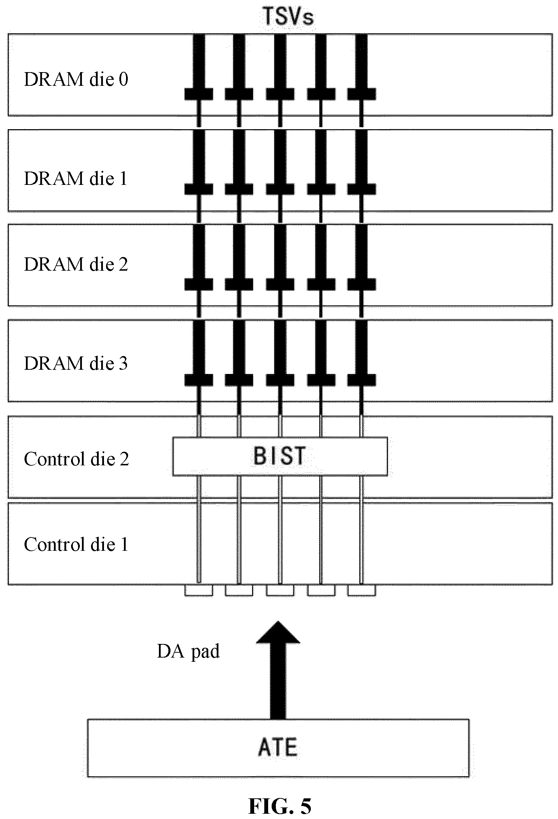

In a storage device with a stacked structure, although vertical stacked structure allows a higher density of memory dies in the same space, it also makes it is difficult for a control die to manage the memory dies. Therefore, in the embodiments shown in FIGS. 4 and 5, a new level of control mechanism may be introduced in addition to the original level of control mechanism. As shown in FIGS. 4 and 5, each TSV memory die may have an independent base/logic die (a control die 2) at a bottom layer, which integrates DRAM dies to manage the entire cluster of the stacked structure. The base/logic die may directly communicate with a control die 1 in a Graphics Processing Unit (GPU)/ a Central Processing Unit (CPU)/ a System on a chip (Soc), etc., and may be configured to collect data in the stacked DRAM dies and help the control die 1 in the GPU/CPU/Soc manage the stacked DRAM dies. In the stacked system, it is not necessary to significantly change the scale of the control die 1 such as the GPU/CPU/Soc. The control die 1 such as the GPU/CPU/Soc, may only need to interact with the control die 2 in the base/logic die, and the control die 2 can manage each layer of the DRAM die in each cluster.

In the embodiment shown in FIG. 4, the BIST circuit may be disposed in the control die 1. In the embodiment shown in FIG. 5, the BIST circuit may be disposed in the control die 2. Regardless its position, the BIST circuit can test, in series or in parallel, any one or more of the DRAM dies stacked on the BIST circuit.

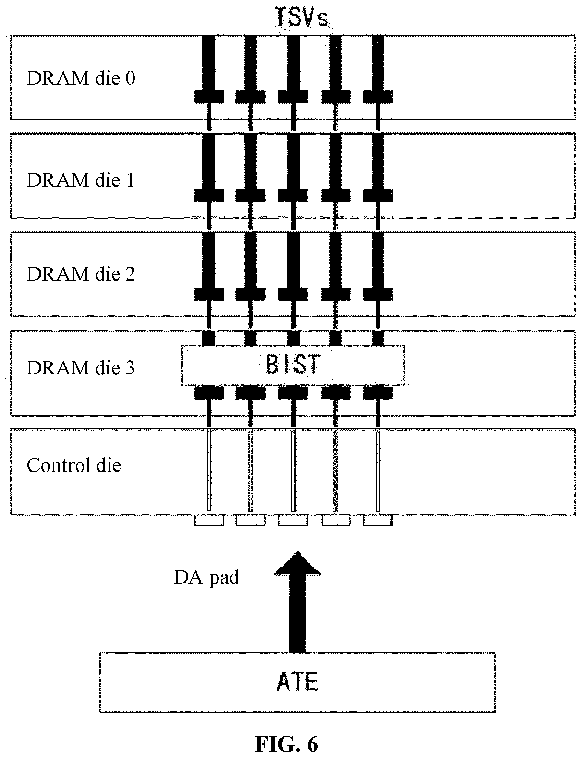

FIGS. 6, 7, and 8 are schematic diagrams of a method for testing a memory according to some embodiments of the disclosure.

The difference between the embodiment shown in FIG. 6 and that shown in FIG. 3 is that the BIST circuit in FIG. 6 may be disposed in any one of the DRAM dies that are vertically stacked on the control die. An example in which the BIST circuit is disposed on the DRAM die 3 is shown in FIG. 6. The BIST circuit herein may also perform the method for testing the memory as described in the foregoing embodiments.

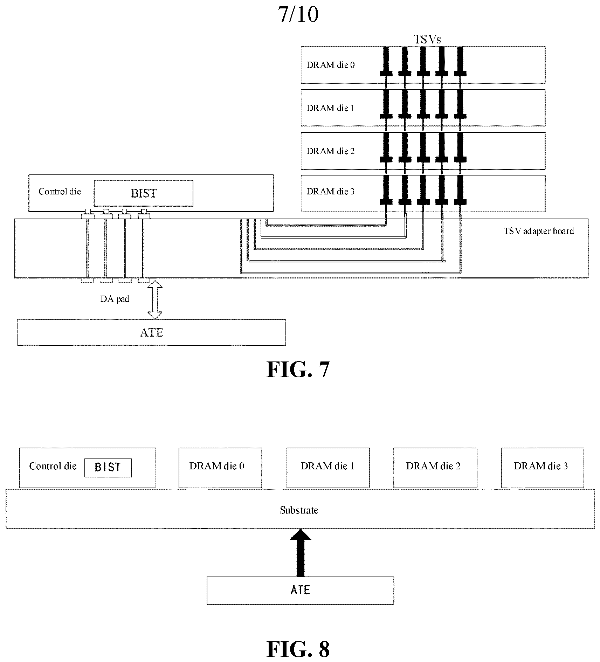

The difference between an embodiment shown in FIG. 7 and that shown in FIG. 3 is that, in FIG. 7, the DRAM dies 0 to 3 may be vertically stacked successively, and the vertically stacked DRAM dies 0 to 3 may be horizontally interconnected to the control die through a TSV adapter board. The BIST circuit of FIG. 7 may also perform the method for testing the memory described in the foregoing embodiments.

The difference between an embodiment shown in FIG. 8 and that shown in FIG. 3 is that, in FIG. 8, the DRAM dies 0 to 3 and the control die may be all horizontally distributed on a substrate of the same storage device. The BIST circuit of FIG. 8 also performs the method for testing the memory described in the foregoing embodiments.

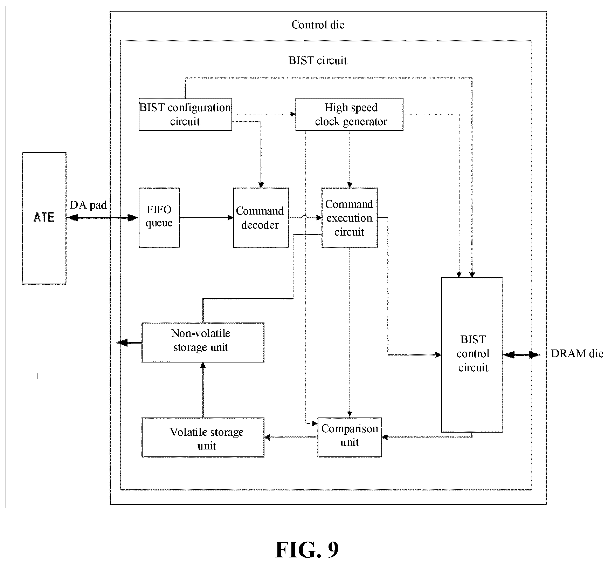

FIG. 9 shows an example that does not fall into the scope of the claims in which the BIST circuit is disposed on the control die in the storage device. As shown in FIG. 9, the BIST circuit includes a BIST configuration circuit, a high-speed clock generator, a FIFO queue, a command decoder, a command execution circuit, a BIST control circuit, a non-volatile storage unit, a volatile storage unit, and a comparison unit.

Referring to FIG. 9, the BIST configuration circuit may be configured to receive configuration information from the ATE. The configuration information may include a frequency of a clock signal, an adopted operating mode, information about whether one memory or all memories are currently tested when the BIST circuit performing the test. The BIST configuration circuit may be connected to the high-speed clock generator, and may send, to the high-speed clock generator, a frequency of a test clock signal that currently needs to be generated, so that the high-speed clock generator may generate a test clock signal of the corresponding frequency based on the frequency. The BIST configuration circuit may be further connected to the command decoder, and may send a currently specified target operating mode to the command decoder, so that the command decoder may parse a received command signal from the ATE based on the currently specified target operating mode. The BIST configuration circuit may be further connected to the BIST control circuit, and may send, to the BIST control circuit, information about whether one of, some of, or all of the memories are currently tested, so that the BIST control circuit may determine a to-be-tested memory based on the information.

Continuing refer to FIG. 9, the high-speed clock generator may be respectively connected to the command execution circuit, the comparison unit, and the BIST control circuit, and then respectively output a test clock signal to the command execution circuit, the comparison unit, and the BIST control circuit. Therefore, the command execution circuit, the comparison unit, and the BIST control circuit may test the to-be-tested memory based on the test clock signal.

In some embodiments of the disclosure, the high-speed clock generator may use, for example, a Phase Locked Loop (PLL), which will not be limited in the disclosure.

In an embodiment that does not fall into the scope of the claims and which is shown in FIG. 9, the FIFO queue may receive and buffer various command signals from the ATE through the DA pads. The command signals may include, but not limited to, a timing set command such as a timing interval/event, signals timing adjust such as an add/reduce CS delay, a normal command such as Active/Precharge, a test mode of DRAM die command (since the BIST circuit needs to use a test mode of the DRAM die to perform a DRAM test), an event loop control command, a voltage/current set/measure command; a MISC command such as a BIST Config command, a reading BIST result command, or a repairing DRAM command, etc. When the FIFO queue is empty, the command execution circuit may stop performing the test process.

In some embodiments of the disclosure, the command decoder may be respectively connected to the FIFO queue, the BIST configuration circuit, and the command execution circuit. And the command decoder may read the command signal from the FIFO queue according to a clock signal output by the ATE, and then parse the read command signal according to the target operating mode output by the BIST configuration circuit to interpret the command signal. When the parsed command signal indicates that a DRAM die is to be tested, the command decoder may send the parsed command signal to the command execution circuit to notify the command execution circuit to start testing the DRAM die.

After receiving the signal from the command decoder, the command execution circuit may generate, according to a to-be-tested data generation algorithm built in the command execution circuit, to-be-tested data configured to test the DRAM die, generate to-be-tested address successively based on the test clock signal, and then send the to-be-tested data and the to-be-tested addresses thereof to the BIST control circuit.

After receiving the to-be-tested data and the to-be-tested address from the command execution circuit, the BIST control circuit may determine, according to information sent by the BIST configuration circuit, whether the current to-be-tested memory is a certain target memory or all of the memories. Then, in response to the to-be-tested memory being the certain target memory, the BIST control circuit may write the to-be-tested data into storage units corresponding to to-be-tested address of the target memory according to the test clock signal. Alternatively, in response to the to-be-tested memory being all of the memories, the BIST control circuit may respectively write the to-be-tested data into the storage units corresponding to to-be-tested address of the memories according to the test clock signal.

The BIST control circuit may send the to-be-tested data to the to-be-tested DRAM die, then read output data from the storage units corresponding to the to-be-tested address, and input the output data to the comparison unit.

The comparison unit may obtain the to-be-tested address and the corresponding to-be-tested data thereof from the command execution circuit, perform one-to-one comparison on the output data and the to-be-tested data of the corresponding to-be-tested address, record a to-be-tested address corresponding to a storage unit with an inconsistent comparison result, and write the to-be-tested address into a volatile storage unit as an incorrect address.

The incorrect address stored in the volatile storage unit may be written into a non-volatile storage unit for storage.

When the storage device is tested again, the command execution circuit may firstly read the incorrect address that is previously recorded from the non-volatile storage unit, and then automatically skip the to-be-tested address that have been previously tested when generating a current to-be-tested address. As such, the storage unit corresponding to the incorrect address may be prevented from being repeatedly tested, thereby reducing computing resource consumption.

In some embodiments of the disclosure, a test result stored in the non-volatile storage unit may be further provided externally, for example, to the control die or the ATE, to notify of a specific storage unit having an error, so that the storage unit may be repaired or replaced.

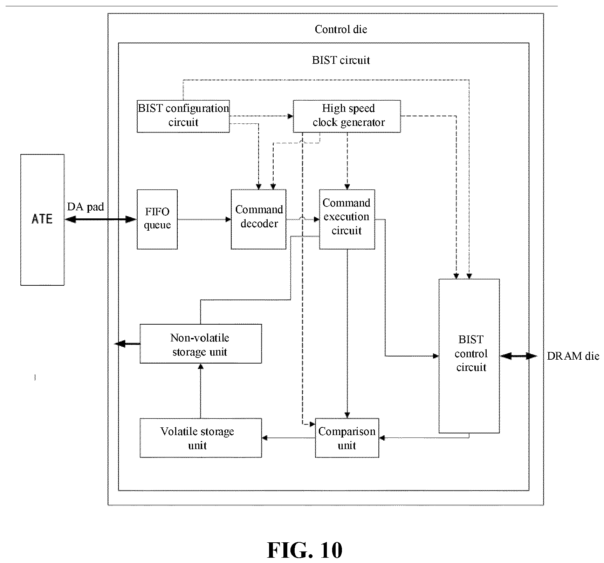

FIG. 10 is a schematic diagram of another embodiment that does also not fall into the scope of the claims. The difference between the embodiment shown in FIG. 10 and that shown in FIG. 9 is that, in FIG. 10, the test clock signal generated by the high-speed clock generator may be directly provided to the command decoder, so that the command decoder may read the command signal from the FIFO queue based on the test clock signal.

According to the method for testing the memory provided in this embodiment of the disclosure, the BIST circuit is configured to test the memory, so that a high-speed clock needed for testing a DRAM may be generated by the high-speed clock generator, such as a PLL, built in the BIST circuit. Therefore, a low-speed clock of the machine may be used to generate a high-speed clock used by the BIST circuit, so that a whole wafer may be tested in one touch down, thereby reducing the test cost and the test time. The ATE may further program the BIST circuit through a small quantity of DA pads, and a command of the ATE may be parsed into a configuration of the BIST circuit, such as a DRAM test mode command, for execution. In addition, the method provided in some embodiments of the disclosure, a same TSV path may be used when accessing the DRAM die and during a normal operation, and the test time sequence is closer to that for the normal operation of the DRAM die. Furthermore, the BIST circuit may simultaneously test all DRAM dies in a stack, thereby reducing the test time.

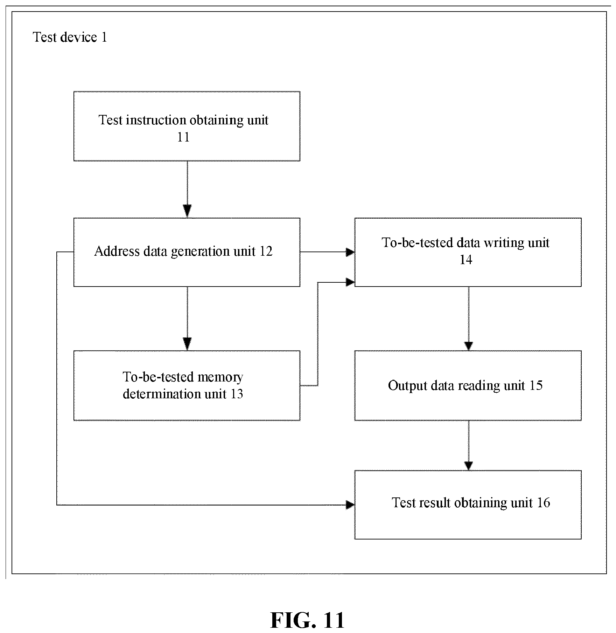

FIG. 11 is a schematic diagram of a device for testing a memory according to an embodiment of the disclosure. As shown in FIG. 11, in some embodiments of the disclosure, the device 1 may include a test instruction obtaining unit 11, an address data generation unit 12, a to-be-tested memory determination unit 13, a to-be-tested data writing unit 14, an output data reading unit 15, and a test result obtaining unit 16.

The test instruction obtaining unit 11 is configured to obtain a test instruction. The address data generation unit 12 is configured to generate, in response to the test instruction, a test clock signal, a to-be-tested address and to-be-tested data. The to-be-tested memory determination unit 13 is configured to determine a to-be-tested memory from memories of a storage device. The storage device includes a self-test circuit. The to-be-tested data writing unit 14 is configured to write the to-be-tested data into a storage unit corresponding to a to-be-tested address of the to-be-tested memory. The output data reading unit 15 is configured to read output data from the storage unit corresponding to the to-be-tested address of the to-be-tested memory. The test result obtaining unit 16 is configured to compare the to-be-tested data with the output data corresponding to the to-be-tested address, to obtain a test result of the to-be-tested memory.

In some embodiments of the disclosure, the self-test circuit may include a FIFO queue. The test instruction obtaining unit 11 may include: a buffering unit, which may be configured to buffer a command signal from an ATE in the FIFO queue. An operating frequency of the test clock signal is higher than a frequency of a clock signal output by the ATE; alternatively, a frequency of the test clock signal is equal to the frequency of the clock signal output by the ATE, and a phase of the test clock signal is different from a phase of the clock signal output by the ATE. The test instruction obtaining unit 11 may further include a signal reading unit, which may be configured to read the command signal from the FIFO queue.

In some embodiments of the disclosure, the test instruction obtaining unit 11 may further include: a mode determination unit, which may be configured to determine a target operating mode of the self-test circuit. The test instruction obtaining unit 11 may further include a command parsing unit, which may be configured to parse the command signal based on the target operating mode, and determine the command signal to be the test instruction.

In some embodiments of the disclosure, the mode determination unit may include: a first configuration information obtaining unit, which may be configured to obtain first configuration information from the ATE. And the mode determination unit may further include a target operating mode determination unit, which may be configured to determine the target operating mode based on the first configuration information.

In some embodiments of the disclosure, the self-test circuit may further include a clock signal generator. The test device 1 may further include: a second configuration information obtaining unit, which may be configured to obtain second configuration information from the ATE. The test device 1 may further include a test frequency determination unit, which may be configured to determine the frequency of the test clock signal based on the second configuration information. And the test device 1 may further include a test clock generation unit, which may be configured to generate, by using the clock signal generator, a test clock signal that has the frequency of the test clock signal.

In some embodiments of the disclosure, the signal reading unit may include: a third configuration information obtaining unit, which may be configured to obtain third configuration information from the ATE. The signal reading unit may further include a reading frequency determination unit, which may be configured to determine a reading frequency of the command signal based on the third configuration information. And the signal reading unit may further include a first command signal reading unit, which may be configured to: in response to the reading frequency being equal to the frequency of the test clock signal, read the command signal from the FIFO queue based on the test clock signal.

In some embodiments of the disclosure, the signal reading unit may further include: a second command signal reading unit, which may be configured to: in response to the reading frequency being equal to the frequency of the clock signal output by the ATE, read the command signal from the FIFO queue based on the clock signal output by the ATE.

In some embodiments of the disclosure, the to-be-tested memory determination unit 13 may include: a fourth configuration information obtaining unit, which may be configured to obtain fourth configuration information from the ATE. And the to-be-tested memory determination unit 13 may further include a to-be-tested memory device determination unit, which may be configured to determine the to-be-tested memory based on the fourth configuration information. The to-be-tested memory may be one or more target memories in the storage device.

In some embodiments of the disclosure, the to-be-tested data writing unit 14 may include a first writing unit, which may be configured to: in response to the to-be-tested memory being one target memory in the storage device, write the to-be-tested data into a storage unit corresponding to a to-be-tested address of the target memory.

In some embodiments of the disclosure, the to-be-tested data writing unit 14 may further include: a second writing unit, which may be configured to: in response to the to-be-tested memory being a plurality of target memories in the storage device, write each of the to-be-tested data into storage units corresponding to a to-be-tested address of a respective one of the plurality of target memories.

In some embodiments of the disclosure, the test result obtaining unit 16 may include: a comparison result obtaining unit, which may be configured to compare the to-be-tested data with the output data corresponding to the to-be-tested address, to obtain a comparison result. And the test result obtaining unit 16 may further include an incorrect address recording unit, which may be configured to: in response to the comparison result being not matching, record the to-be-tested address corresponding to the to-be-tested data as an incorrect address, where the test result may include the incorrect address.

In some embodiments of the disclosure, the self-test circuit includes a volatile storage unit and a non-volatile storage unit. The test device 1 may further include: a test result buffering unit, which may be configured to write the test result of the to-be-tested memory into the volatile storage unit. And the test device 1 may further include a test result storage unit, which may be configured to write the test result in the volatile storage unit into the non-volatile storage unit for storage.

In some embodiments of the disclosure, the self-test circuit includes a non-volatile storage unit, and the non-volatile storage unit is configured to store an incorrect address of the to-be-tested memory. The address data generation unit 12 may include an incorrect address obtaining unit, which may be configured to obtain the incorrect address stored in the non-volatile storage unit. And the address data generation unit 12 may further include a to-be-tested address generation unit, which may be configured to skip automatically the incorrect address when generating the to-be-tested address.

In some embodiments of the disclosure, the storage device may further include a control die, and the self-test circuit may be arranged in the control die.

In some embodiments of the disclosure, the memories of the storage device may be vertically stacked above or beneath the control die.

In some embodiments of the disclosure, the self-test circuit may be arranged in the memories of the storage device.

In some embodiments of the disclosure, the test device 1 may be disposed in the self-test circuit.

The disclosure further provides an electronic device. The electronic device includes one or more processors and a storage device, the storage device being configured to store one or more programs. Upon being executed by the one or more processors, the one or more programs cause the one or more processors to perform the method according to any one of the foregoing embodiments.

The disclosure further provides a computer-readable storage medium in which a computer program is stored. Upon being executed by a processor, the computer program may cause the method of any one of the foregoing embodiments to be performed. The foregoing method embodiments may be referred to for details, which will not be repeatedly presented herein for the sake of conciseness.

Those skilled in the art can easily figure out other embodiments of the disclosure after considering the specification and practicing the invention that is disclosed herein. This application is intended to cover any variations, functions, or adaptive changes of the present invention. These variations, functions, or adaptive changes comply with general principles of the present invention and include common knowledge or a conventional technical means in the technical field that is not disclosed in the disclosure.

## Claims

1. A method for testing a memory, comprising:
obtaining (S210) a test instruction from an automatic test equipment, ATE;
generating (S220), in response to the test instruction, a test clock signal, a to-be-tested address and to-be-tested data;
determining (S230) a to-be-tested memory from memories of a storage device, the storage device comprising a control die that has a built-in self-test, BIST, circuit on which the memories are stacked, wherein each of the memories has a limited quantity of command pins connected to the BIST circuit to obtain the test instruction from the ATE;
writing (S240) the to-be-tested data into a storage unit corresponding to a to-be-tested address of the to-be-tested memory;
reading (S250) output data from the storage unit corresponding to the to-be-tested address of the to-be-tested memory; and
comparing (S260) the to-be-tested data with the output data corresponding to the to-be-tested address, to obtain a test result of the to-be-tested memory,
wherein, the BIST circuit comprises a first-in-first-out queue; and obtaining the test instruction comprises:
buffering a command signal from an automatic test equipment in the first-in-first-out queue, wherein a frequency of the test clock signal is equal to a frequency of a clock signal output by the automatic test equipment, and a phase of the test clock signal is different from a phase of the clock signal output by the automatic test equipment, wherein the BIST circuit further comprises a clock signal generator that generates the test clock signal; and
reading the command signal from the first-in-first-out queue.

2. The method for testing the memory of claim 1, wherein obtaining the test instruction further comprises:
determining a target operating mode of the BIST; and
parsing the command signal based on the target operating mode and determining the command signal to be the test instruction,
wherein determining the target operating mode of the BIST circuit comprises:
obtaining, from the automatic test equipment, first configuration information; and
determining, based on the first configuration information, the target operating mode.

3. The method for testing the memory of claim 1, further comprising:
obtaining, from the automatic test equipment, second configuration information;
determining, based on the second configuration information, the frequency of the test clock signal; and
generating, by using the clock signal generator, a test clock signal that has the frequency of the test clock signal.

4. The method for testing the memory of claim 1, wherein reading the command signal from the first-in-first-out queue comprises:
obtaining, from the automatic test equipment, third configuration information;
determining, based on the third configuration information, a reading frequency of the command signal; and
in response to the reading frequency being equal to the frequency of the test clock signal, reading, based on the test clock signal, the command signal from the first-in-first-out queue.

5. The method for testing the memory of claim 4, wherein reading the command signal from the first-in-first-out queue further comprises:
in response to the reading frequency being equal to the frequency of the clock signal output by the automatic test equipment, reading, based on the clock signal output by the automatic test equipment, the command signal from the first-in-first-out queue.

6. The method for testing the memory of claim 1, wherein determining the to-be-tested memory from the memories of the storage device comprises:
obtaining, from the automatic test equipment, fourth configuration information; and
determining, based on the fourth configuration information, the to-be-tested memory, the to-be-tested memory being one or more target memories in the storage device.

7. The method for testing the memory of claim 6, wherein writing the to-be-tested data into the storage unit corresponding to the to-be-tested address of the to-be-tested memory comprises:
in response to the to-be-tested memory being one target memory in the storage device, writing the to-be-tested data into a storage unit corresponding to a to-be-tested address of the target memory.

8. The method for testing the memory of claim 6, wherein writing the to-be-tested data into the storage unit corresponding to the to-be-tested address of the to-be-tested memory comprises:
in response to the to-be-tested memory being a plurality of target memories in the storage device, writing each of the to-be-tested data into storage units corresponding to a to-be-tested address of a respective one of the plurality of target memories.

9. The method for testing the memory of claim 1, wherein comparing the to-be-tested data with the output data corresponding to the to-be-tested address, to obtain the test result of the to-be-tested memory comprises:
comparing the to-be-tested data with the output data corresponding to the to-be-tested address, to obtain a comparison result; and
in response to the comparison result being not matching, recording the to-be-tested address corresponding to the to-be-tested data as an incorrect address, the test result comprising the incorrect address.

10. The method for testing the memory of claim 9, wherein the BIST circuit comprises a volatile storage unit and a non-volatile storage unit, and the method further comprises:
writing the test result of the to-be-tested memory into the volatile storage unit; and
writing the test result in the volatile storage unit into the non-volatile storage unit for storage.

11. The method for testing the memory of claim 1, wherein the BIST circuit comprises a non-volatile storage unit, configured to store an incorrect address of the to-be-tested memory; and generating, in response to the test instruction, the to-be-tested address comprises:
obtaining the incorrect address stored in the non-volatile storage unit; and
skipping automatically the incorrect address when generating the to-be-tested address.

12. A computer-readable storage medium storing a computer program, wherein upon being executed by a processor, the computer program causes the method of any one of claims 1-11 to be performed.

## Patentansprüche

1. Verfahren zum Testen eines Datenspeichers, das Folgendes umfasst:
Erhalten (S210) einer Testanweisung von einer automatischen Testausrüstung, ATE;
Erzeugen (S220) eines Testtaktsignals, einer zu testenden Adresse und von zu testenden Daten in Reaktion auf die Testanweisung;
Bestimmen (S230) eines zu testenden Datenspeichers von Datenspeichern einer Speichervorrichtung, wobei die Speichervorrichtung einen Steuerchip umfasst, der eine eingebaute Selbsttest, BIST, -Schaltung aufweist, auf der die Datenspeicher gestapelt sind, wobei jeder der Datenspeicher eine begrenzte Menge von Befehlsstiften aufweist, die mit der BIST-Schaltung verbunden sind, um die Testanweisung von der ATE zu erhalten;
Schreiben (S240) der zu testenden Daten in eine Speichereinheit, die einer zu testenden Adresse des zu testenden Datenspeichers entspricht;
Lesen (S250) von Ausgabedaten von der Speichereinheit, die der zu testenden Adresse des zu testenden Datenspeichers entspricht; und
Vergleichen (S260) der zu testenden Daten mit den Ausgabedaten, die der zu testenden Adresse entsprechen, um ein Testergebnis des zu testenden Datenspeichers zu erhalten,
wobei die BIST-Schaltung eine First-in-First-out-Warteschlange umfasst und das Erhalten der Testanweisung Folgendes umfasst:
Puffern eines Befehlssignals von einer automatischen Testausrüstung in der First-in-First-out-Warteschlange, wobei eine Frequenz des Testtaktsignals gleich einer Frequenz eines Taktsignals ist, die von der automatischen Testausrüstung ausgegeben wird, und eine Phase des Testtaktsignals sich von einer Phase des Taktsignals, das von der automatischen Testausrüstung ausgegeben wird, unterscheidet, wobei die BIST-Schaltung ferner einen Taktsignalgenerator umfasst, der das Taktsignal erzeugt; und
Lesen des Befehlssignals in der First-in-First-out-Warteschlange.

2. Verfahren zum Testen des Datenspeichers nach Anspruch 1, wobei das Erhalten der Testanweisung ferner Folgendes umfasst:
Bestimmen eines Zielbetriebsmodus der BIST und
Parsen des Befehlssignals auf Basis des Zielbetriebsmodus und Bestimmen, dass das Befehlssignal die Testanweisung ist,
wobei das Bestimmen des Zielbetriebsmodus der BIST-Schaltung Folgendes umfasst:
Erhalten von ersten Auslegungsinformationen von der automatischen Testausrüstung und
Bestimmen des Zielbetriebsmodus auf Basis der ersten Auslegungsinformationen.

3. Verfahren zum Testen des Datenspeichers nach Anspruch 1, ferner umfassend:
Erhalten von zweiten Auslegungsinformationen von der automatischen Testausrüstung;
Bestimmen der Frequenz des Testtaktsignals auf Basis der zweiten Auslegungsinformationen und
Erzeugen eines Testtaktsignals unter Verwendung des Taktsignalgenerators, das die Frequenz des Testtaktsignals aufweist.

4. Verfahren zum Testen des Datenspeichers nach Anspruch 1, wobei das Lesen des Befehlssignals in der First-in-First-out-Warteschlange Folgendes umfasst:
Erhalten von dritten Auslegungsinformationen von der automatischen Testausrüstung;
Bestimmen einer Lesefrequenz des Befehlssignals auf Basis der dritten Auslegungsinformationen und
in Reaktion darauf, dass die Lesefrequenz gleich der Frequenz des Testtaktsignals ist, Lesen des Befehlssignals in der First-in-First-out-Warteschlange auf Basis des Testtaktsignals.

5. Verfahren zum Testen des Datenspeichers nach Anspruch 4, wobei das Lesen des Befehlssignals in der First-in-First-out-Warteschlange ferner Folgendes umfasst:
in Reaktion darauf, dass die Lesefrequenz gleich der Frequenz des Taktsignals ist, das von der automatischen Testausrüstung ausgegeben wird, Lesen des Befehlssignals in der First-in-First-out-Warteschlange auf Basis des von der automatischen Testausrüstung ausgegebenen Taktsignals.

6. Verfahren zum Testen des Datenspeichers nach Anspruch 1, wobei das Bestimmen des zu testenden Datenspeichers der Datenspeicher der Speichervorrichtung Folgendes umfasst:
Erhalten von vierten Auslegungsinformationen von der automatischen Testausrüstung und
Bestimmen des zu testenden Datenspeichers auf Basis der vierten Auslegungsinformationen, wobei es sich bei dem zu testenden Datenspeicher um einen oder mehrere Zieldatenspeicher in der Speichervorrichtung handelt.

7. Verfahren zum Testen des Datenspeichers nach Anspruch 6, wobei das Schreiben der zu testenden Daten in die Speichereinheit, die der zu testenden Adresse des zu testenden Datenspeichers entspricht, Folgendes umfasst:
in Reaktion darauf, dass der zu testende Datenspeicher ein Zieldatenspeicher in der Speichervorrichtung ist, Schreiben der zu testenden Daten in eine Speichereinheit, die einer zu testenden Adresse des Soldatenspeichers entspricht.

8. Verfahren zum Testen des Datenspeichers nach Anspruch 6, wobei das Schreiben der zu testenden Daten in die Speichereinheit, die der zu testenden Adresse des zu testenden Datenspeichers entspricht, Folgendes umfasst:
in Reaktion darauf, dass der zu testende Datenspeicher eine Vielzahl von Zieldatenspeichern in der Speichervorrichtung ist, Schreiben von allen zu testenden Daten in Speichereinheiten, die einer zu testenden Adresse eines jeweiligen der Vielzahl von Zieldatenspeichern entsprechen.

9. Verfahren zum Testen des Datenspeichers nach Anspruch 1, wobei das Vergleichen der zu testenden Daten mit den Ausgabedaten, die der zu testenden Adresse entsprechen, um das Testergebnis des zu testenden Datenspeichers zu erhalten, Folgendes umfasst:
Vergleichen der zu testenden Daten mit den Ausgabedaten, die der zu testenden Adresse entsprechen, um ein Vergleichsergebnis zu erhalten; und
in Reaktion darauf, dass das Vergleichsergebnis keine Übereinstimmung anzeigt, Aufzeichnen der zu testenden Adresse, die den zu testenden Daten entspricht, als eine falsche Adresse, wobei das Testergebnis die falsche Adresse umfasst.

10. Verfahren zum Testen des Datenspeichers nach Anspruch 9, wobei die BIST-Schaltung eine flüchtige Speichereinheit und eine nichtflüchtige Speichereinheit umfasst und das Verfahren ferner Folgendes umfasst:
Schreiben des Testergebnisses des zu testenden Datenspeichers in die flüchtige Speichereinheit und
Schreiben des Testergebnisses in der flüchtigen Speichereinheit zum Speichern in die nichtflüchtige Speichereinheit.

11. Verfahren zum Testen des Datenspeichers nach Anspruch 1, wobei die BIST-Schaltung eine nichtflüchtige Speichereinheit umfasst, die dazu ausgelegt ist, eine falsche Adresse des zu testenden Datenspeichers zu speichern; und das Erzeugen der zu testenden Adresse in Reaktion auf die Testanweisung Folgendes umfasst:
Erhalten der in der nichtflüchtigen Speichereinheit gespeicherten falschen Adresse und
automatisches Überspringen der falschen Adresse, wenn die zu testende Adresse erzeugt wird.

12. Computerlesbares Speichermedium, auf dem ein Computerprogramm gespeichert ist, wobei das Computerprogramm nach Ausführung durch einen Prozessor das Durchführen des Verfahrens nach einem der Ansprüche 1 bis 11 veranlasst.

## Revendications

1. Procédé pour tester une mémoire, comprenant les étapes consistant à :
obtenir (S210) une instruction de test à partir d'un équipement de test automatique, ATE ;
générer (S220), en réponse à l'instruction de test, un signal d'horloge de test, une adresse à tester et des données à tester ;
déterminer (S230) une mémoire à tester à partir des mémoires d'un dispositif de stockage, le dispositif de stockage comprenant une puce de commande qui possède un circuit d'auto-test, BIST, intégré sur lequel les mémoires sont empilées, dans lequel chacune des mémoires dispose d'une quantité limitée de broches de commande connectées au circuit BIST pour obtenir l'instruction de test de l'ATE ;
écrire (S240) les données à tester dans une unité de stockage correspondant à une adresse à tester de la mémoire à tester ;
lire (S250) les données de sortie de l'unité de stockage correspondant à l'adresse à tester de la mémoire à tester ; et
comparer (S260) les données à tester avec les données de sortie correspondant à l'adresse à tester, pour obtenir un résultat de test de la mémoire à tester,
dans lequel le circuit BIST comprend une file d'attente premier entré, premier sorti ; et l'obtention de l'instruction de test comprend les étapes consistant à :
mettre en mémoire tampon un signal de commande provenant d'un équipement de test automatique dans la file d'attente premier entré, premier sorti, dans lequel une fréquence du signal d'horloge de test est égale à une fréquence d'un signal d'horloge émis par l'équipement de test automatique, et une phase du test le signal d'horloge est différent d'une phase du signal d'horloge émis par l'équipement de test automatique, le circuit BIST comprenant en outre un générateur de signal d'horloge qui génère le signal d'horloge de test ; et
lire le signal de commande à partir de la file d'attente premier entré, premier sorti.

2. Procédé de test de la mémoire selon la revendication 1, dans lequel l'obtention de l'instruction de test comprend en outre les étapes consistant à :
déterminer un mode de fonctionnement cible du BIST ; et
analyser le signal de commande sur la base du mode de fonctionnement cible et déterminer que le signal de commande est l'instruction de test,
dans lequel la détermination du mode de fonctionnement cible du circuit BIST comprend les étapes consistant à :
obtenir, à partir de l'équipement de test automatique, des premières informations de configuration ; et
déterminer, sur la base des premières informations de configuration, le mode de fonctionnement cible.

3. Procédé de test de la mémoire selon la revendication 1, comprenant en outre les étapes consistant à :
obtenir, à partir de l'équipement de test automatique, des secondes informations de configuration ;
déterminer, sur la base des secondes informations de configuration, la fréquence du signal d'horloge de test ; et
générer, à l'aide du générateur de signal d'horloge, un signal d'horloge de test qui a la fréquence du signal d'horloge de test.

4. Procédé de test de mémoire selon la revendication 1, dans lequel la lecture du signal de commande dans la file d'attente premier entré, premier sorti comprend les étapes consistant à :
obtenir, à partir de l'équipement de test automatique, des troisièmes informations de configuration ;
déterminer, sur la base des troisièmes informations de configuration, une fréquence de lecture du signal de commande ; et
en réponse au fait que la fréquence de lecture est égale à la fréquence du signal d'horloge de test, lire, sur la base du signal d'horloge de test, le signal de commande provenant de la file d'attente premier entré, premier sorti.

5. Procédé de test de la mémoire selon la revendication 4, dans lequel la lecture du signal de commande de la file d'attente premier entré, premier sorti comprend en outre l'étape consistant à :
en réponse au fait que la fréquence de lecture est égale à la fréquence du signal d'horloge délivré par l'équipement de test automatique, lire, sur la base du signal d'horloge délivré par l'équipement de test automatique, le signal de commande provenant de la file d'attente premier entré, premier sorti.

6. Procédé de test de mémoire selon la revendication 1, dans lequel la détermination de la mémoire à tester à partir des mémoires du dispositif de stockage comprend les étapes consistant à :
obtenir, à partir de l'équipement de test automatique, des quatrièmes informations de configuration ; et
déterminer, sur la base des quatrièmes informations de configuration, la mémoire à tester, la mémoire à tester étant une ou plusieurs mémoires cibles dans le dispositif de stockage.

7. Procédé de test de la mémoire selon la revendication 6, dans lequel l'écriture des données à tester dans l'unité de stockage correspondant à l'adresse à tester de la mémoire à tester comprend l'étape consistant à :
en réponse au fait que la mémoire à tester est une mémoire cible dans le dispositif de stockage, écrire les données à tester dans une unité de stockage correspondant à une adresse à tester de la mémoire cible.

8. Procédé de test de la mémoire selon la revendication 6, dans lequel l'écriture des données à tester dans l'unité de stockage correspondant à l'adresse à tester de la mémoire à tester comprend l'étape consistant à :
en réponse au fait que la mémoire à tester est une pluralité de mémoires cibles dans le dispositif de stockage, écrire chacune des données à tester dans des unités de stockage correspondant à une adresse à tester d'une mémoire respective parmi la pluralité de mémoires cibles.

9. Procédé de test de la mémoire selon la revendication 1, dans lequel la comparaison des données à tester avec les données de sortie correspondant à l'adresse à tester, pour obtenir le résultat du test de la mémoire à tester comprend les étapes consistant à :
comparer les données à tester avec les données de sortie correspondant à l'adresse à tester, pour obtenir un résultat de comparaison ; et
en réponse au résultat de comparaison qui ne correspond pas, enregistrer l'adresse à tester correspondant aux données à tester comme adresse incorrecte, le résultat de test comprenant l'adresse incorrecte.

10. Procédé de test de mémoire selon la revendication 9, dans lequel le circuit BIST comprend une unité de stockage volatile et une unité de stockage non volatile, et le procédé comprend en outre les étapes consistant à :
écrire le résultat du test de la mémoire à tester dans l'unité de stockage volatile ; et
écrire le résultat du test dans l'unité de stockage volatile dans l'unité de stockage non volatile pour le stockage.

11. Procédé de test de mémoire selon la revendication 1, dans lequel le circuit BIST comprend une unité de stockage non volatile, configurée pour stocker une adresse incorrecte de la mémoire à tester ; et générer, en réponse à l'instruction de test, l'adresse à tester comprend les étapes consistant à :
obtenir l'adresse incorrecte stockée dans l'unité de stockage non volatile ; et
sauter automatiquement l'adresse incorrecte lors de la génération de l'adresse à tester.

12. Support de stockage lisible par ordinateur stockant un programme informatique, dans lequel, après avoir été exécuté par un processeur, le programme informatique provoque l'exécution du procédé selon l'une quelconque des revendications 1 à 11.
